# EUROPEAN PATENT APPLICATION

(11) **EP 2 663 072 A1**
(43) Date of publication of application: **13.11.2013**
(21) Application number: 11854605.0
(22) Date of filing: 14.12.2011
(51) Int. Cl.: H04N 5/64, H05K 7/20

(54) **ELECTRONIC EQUIPMENT**

(30) Priority: 07.01.2011 JP 2011001751
(71) Applicant: Panasonic Corporation, Osaka 571-8501 (JP)
(72) Inventor: WAKAMATSU, Tomonori, Osaka-shi Osaka 540-6207 (JP)
(74) Representative: Grünecker, Kinkeldey, Stockmair & Schwanhäusser
(86) International application number: PCT/JP2011/006973
(87) International publication number: WO 2012/093444

(57) **Abstract**

Electronic equipment includes a body case, a control unit, a partition board, and a heat exchanger attached to the partition board. The heat exchanger includes a hot-air passage for carrying hot air heated in the body case; a first blower for blowing the hot air into the hot-air passage; a cool-air passage for carrying cooling air from outside the body case, the cooling air being lower in temperature than the hot air; and a second blower for blowing the cooling air into the cool-air passage.

## Description

### TECHNICAL FIELD

The present invention relates to electronic equipment.

### BACKGROUND ART

Electronic equipment such as television receivers has a body case, a display unit on the front side of the body case, and a control unit for the display unit inside the body case. The rear surface of the control unit in the body case is covered by a partition board. Such television receivers are often suspended from the ceiling (see, for example, Patent Literature 1).

Television receivers have been equipped with increasingly large display units in recent years, and there have been efforts to install them outdoors as advertising devices by making use of their high visual effects.

Television receivers used outdoors need to be configured to protect the body case from rain infiltration. For this purpose, the front and rear openings of the body case are sealed by the display unit and the partition board, respectively. This sealed structure, however, prevents heat from being fully released from the display unit and the control unit in the body case.

To avoid the above problem, the conventional television receivers have the following components: a metal partition board disposed on the rear side of the body case, a plurality of metal fins both inside and outside the partition board, and a blower for stirring the air in the body case. Thus, the heat inside the body case is stirred by the blower, and is conducted to the fins inside the body case, and then to the partition board. The heat is then conducted to the fins outside the body case, thereby being released outdoors.

As well known, however, a plurality of metal fins disposed both inside and outside a metal partition board are very heavy, causing television receivers to be too heavy to be installed at high points outdoors.

### Citation List

### Patent Literature

Patent Literature 1: Japanese Patent Unexamined Publication No. H07-322172

### SUMMARY OF THE INVENTION

The present invention is directed to provide electronic equipment including: a body case including a display unit on the front side thereof; a control unit disposed in the body case; a partition board attached to a rear opening formed on a rear side of the body case so as to separate an inside of the body case from an outside of the body case; and a heat exchanger attached to the partition board. The heat exchanger includes: a hot-air passage for carrying hot air heated in the body case; a first blower for blowing the hot air into the hot-air passage; a cool-air passage for carrying cooling air from outside the body case, the cooling air being lower in temperature than the hot air; and a second blower for blowing the cooling air into the cool-air passage.

In the electronic equipment with this configuration, the first blower blows hot air generated in the body case into the hot-air passage, and the second blower blows cooling air outside the body case into the cool-air passage. Thus, electronic equipment performs effective cooling of the body case in spite of being light weight.

### BRIEF DESCRIPTION OF DRAWINGS

Fig. 1 is a perspective view of an example of installation of electronic equipment according to an exemplary embodiment of the present invention.
Fig. 2 is a front perspective view of the electronic equipment.
Fig. 3 is a rear perspective view of the electronic equipment.
Fig. 4 is a rear perspective view of the electronic equipment when seen in a different direction from Fig. 3.
Fig. 5 is an exploded rear perspective view of the electronic equipment.
Fig. 6 is a rear perspective view of the electronic equipment from which a heat exchanger and a cover are removed.
Fig. 7 is a perspective view of the heat exchanger of the electronic equipment.
Fig. 8 is an exploded perspective view of the heat exchanger of the electronic equipment.
Fig. 9 is a top sectional view of the electronic equipment showing an airflow generated when a first blower is driven.
Fig. 10 is a top sectional view of the electronic equipment, showing an airflow generated when a second blower is driven.
Fig. 11 is a perspective view of the electronic equipment, showing hot-air passages.
Fig. 12 is a perspective view of the electronic equipment, showing cool-air passages.

### DESCRIPTION OF EMBODIMENT

An exemplary embodiment of the present invention will be described as follows with reference to accompanying drawings. Note that, in the following description, the "front" is the side on which a display unit is disposed in the electronic equipment, and the "rear" is the side opposite to the front.

### Exemplary Embodiment

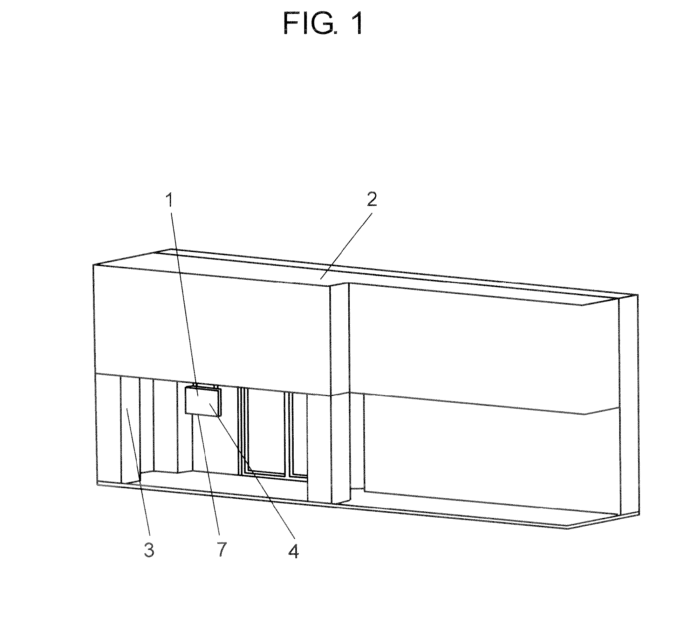

Fig. 1 is a perspective view of an example of installation of electronic equipment according to an exemplary embodiment of the present invention. Electronic equipment 1 not only functions as a television receiver, but also can be used to display advertisements in the open air. In Fig.1, electronic equipment 1 is installed under the eaves 3 of shop 2, and includes display unit 4 having a horizontally long rectangular shape (a kind of square).

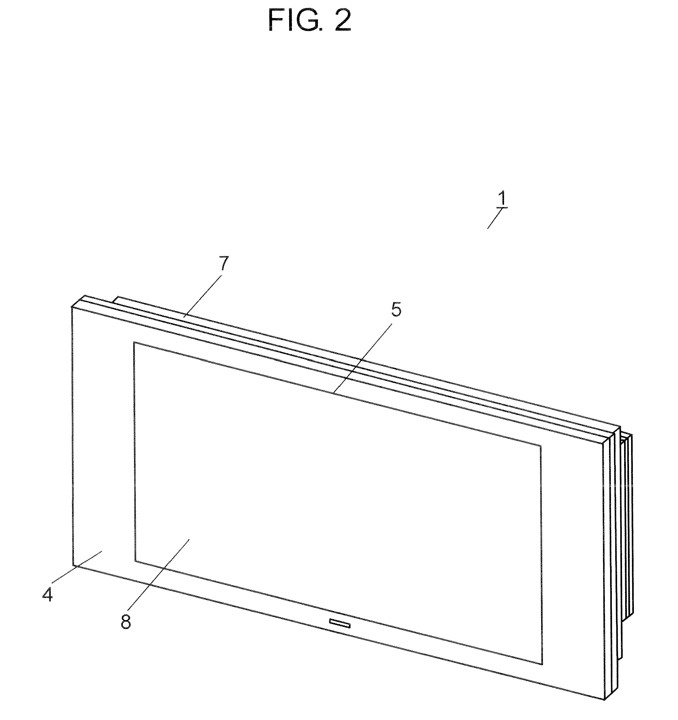

Fig. 2 is a front perspective view of the electronic equipment according to the present invention. As shown in Fig. 2, electronic equipment 1 includes body case 7 having a horizontally long rectangular shape. Body case 7 has front opening 5 covered by transparent plate 8. Display unit 4 is stored on the front side of body case 7.

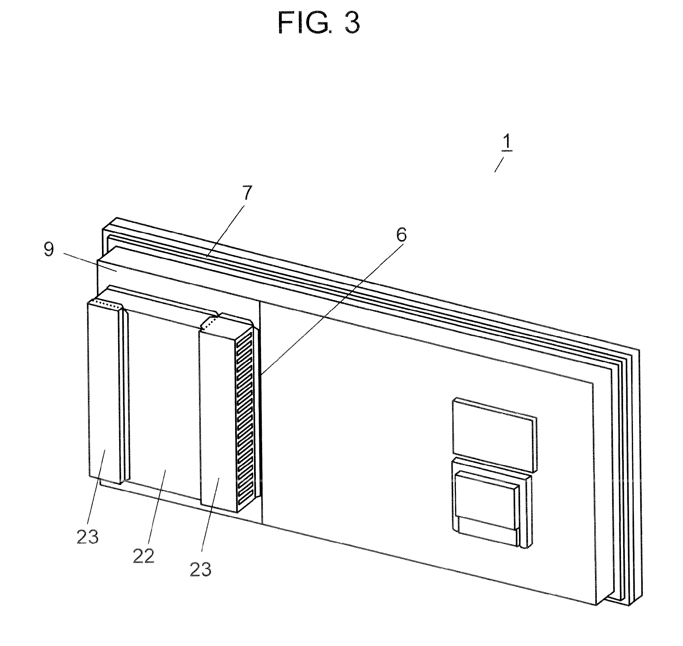

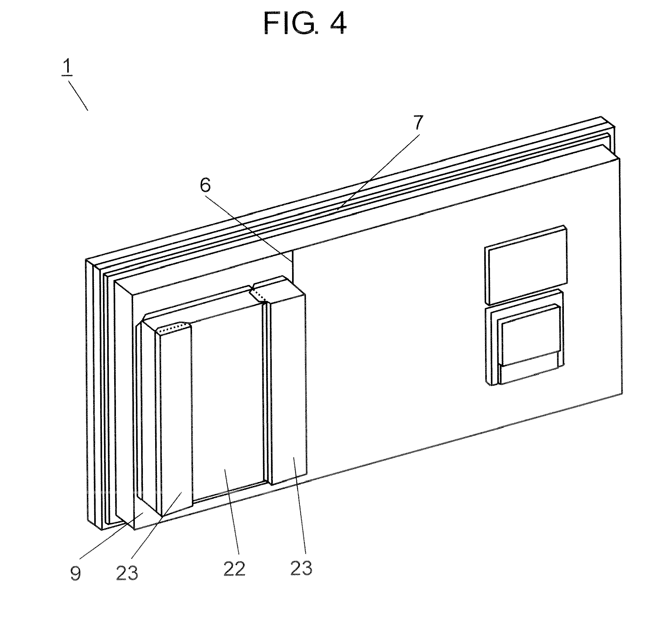

Fig. 3 is a rear perspective view of the electronic equipment according to the present invention, and Fig. 4 is a rear perspective view of the electronic equipment when seen in a different direction from Fig. 3. As shown in Figs. 3 and 4, body case 7 has rear opening 6, which is covered by partition board 9. Thus, partition board 9 is attached to rear opening 6 formed on the rear side of body case 7, thereby partitioning the inside and outside of body case 7.

More specifically, front opening 5 of body case 7 is covered by transparent plate 8 as shown in Fig. 2, and rear opening 6 is covered by partition board 9 as shown in Fig. 3, so that body case 7 can be protected from rain infiltration.

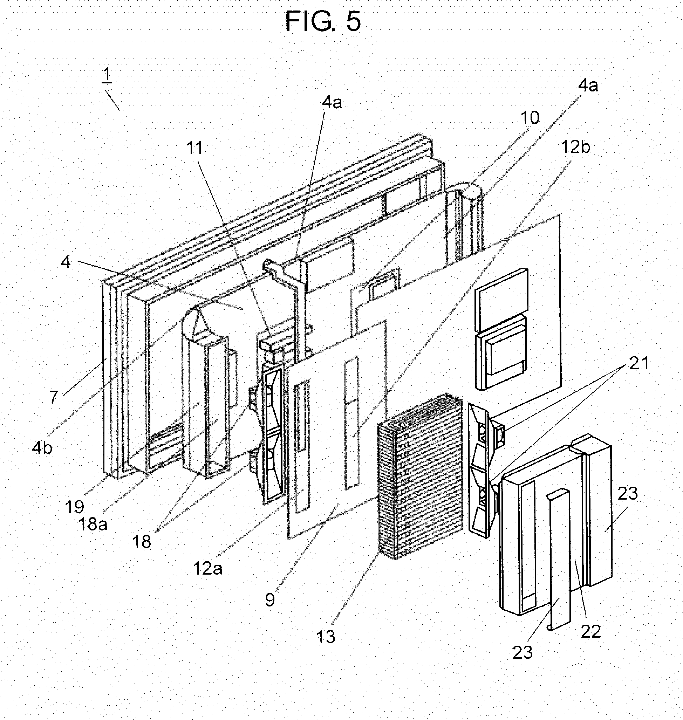

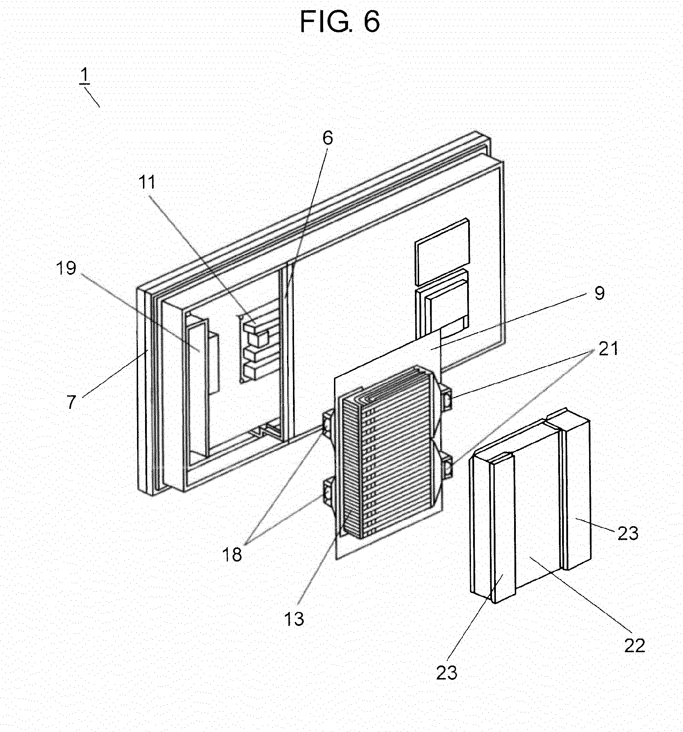

Fig. 5 is an exploded rear perspective view of the electronic equipment of the present invention. Fig. 6 is a rear perspective view of the electronic equipment from which a heat exchanger and a cover are removed. As shown in Fig. 5, electronic equipment 1 includes control units 10 and 11 for display unit 4 disposed on an inner rear side of body case 7.

Partition board 9 includes first vent 12a and second vent 12b. As shown in Figs. 5 and 6, electronic equipment 1 includes heat exchanger 13 attached to the outer side of partition board 9. This configuration minimizes the projection of electronic equipment 1 on its rear side, allowing electronic equipment 1 to be installed in a narrow space.

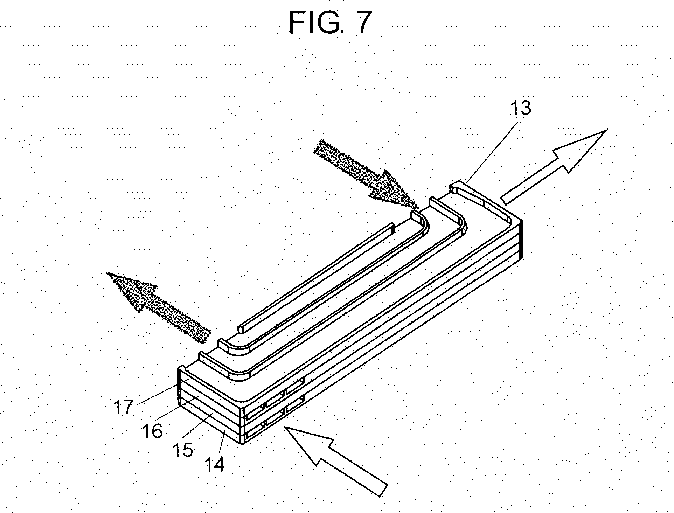

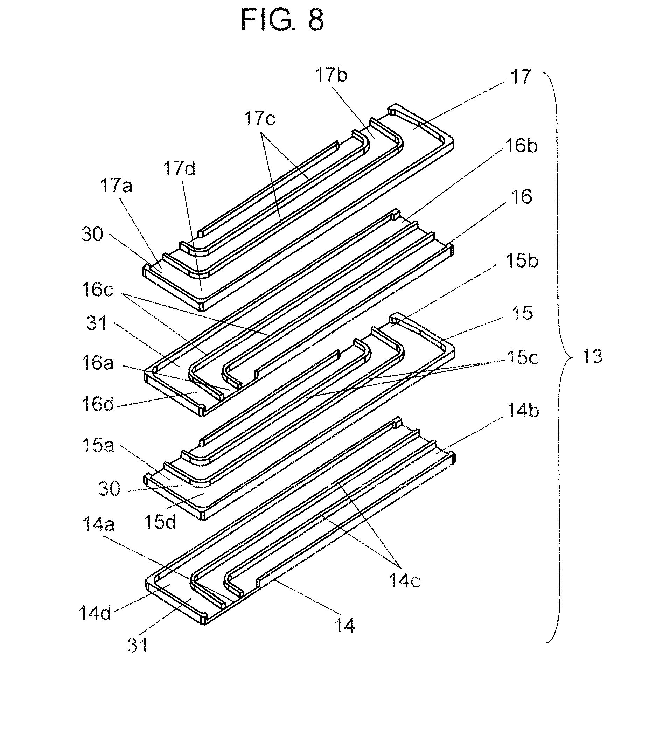

Fig. 7 is a perspective view of the heat exchanger of the electronic equipment according to the exemplary embodiment of the present invention, and Fig. 8 is an exploded perspective view of the heat exchanger of the electronic equipment. Heat exchanger 13 shown in Figs. 7 and 8 is composed of several tens of boards 14, 15, 16, and 17, which are stacked in this order from the bottom at predetermined intervals. As shown in Fig. 8, boards 14 and 16 have openings 14a and openings 16a, respectively, at the front left, and further have openings 14b and openings 16b, respectively, at the right side. Boards 14 and 16 have ribs 14c and ribs 16c, respectively. Ribs 14c divide openings 14a and 14b each into three lanes, whereas ribs 16c divide openings 16a and 16b each into three lanes. The spaces between ribs 14c, and the spaces between ribs 16c function as air passageways 14d and air passageways 16d, respectively.

As shown in Fig. 8, boards 15 and 17 have openings 15a and openings 17a, respectively, at the left back, and further have openings 15b and openings 17b, respectively, at the right back. Boards 15 and 17 have ribs 15c and ribs 17c, respectively. Ribs 15c divide openings 15a and 15b each into three lanes, whereas ribs 17c divide openings 17a and 17b each into three lanes. The spaces between ribs 15c, and the spaces between ribs 17c function as air passageways 15d and air passageways 17d, respectively.

Thus, heat exchanger 13 is composed of a plurality of boards 14, 15, 16, and 17 stacked at predetermined intervals. Boards 14, 15, 16, and 17 include air passageways 14d, 15d, 16d and 17d, respectively, which are formed by using ribs 14c, 15c, 16c, and 17c, respectively. Furthermore, air passageways 14d, 15d, 16d and 17d of boards 14, 15, 16, and 17 are assigned as to be cool-air passages 31 and hot-air passages 30 in alternate order. With this configuration, the hot air flows in a direction opposite to the cooling air, thereby being cooled efficiently. Hot-air passages 30 carry the hot air, which is heated in body case 7. Cool-air passages 31 carry the cooling air outside body case 7, the cooling air being lower in temperature than the hot air.

Openings 15a and 17a of boards 15 and 17 are coupled to first vent 12a, whereas openings 15b and 17b are coupled to second vent 12b shown in Fig. 5. This configuration allows air passageways 15d and 17d to function as hot-air passages 30. Thus, first vent 12a is coupled to openings 15a and 17a, which are at one end of each of hot-air passages 30, whereas second vent 12b is coupled to openings 15b and 17b, which are at the other end of each of hot-air passages 30. Heat exchanger 13 is directly attached to partition board 9 without providing airflow guides, thereby eliminating the need to consider the pressure loss and space occupancy of the airflow guides. The absence of airflow guides minimizes the projection of electronic equipment 1 on its rear side, allowing electronic equipment 1 to be installed in a narrow space. In addition, electronic equipment 1 can be lighter weight, thereby simplifying a fixing device and hence increasing the degree of freedom in installation.

Openings 14a and 14b of board 14 and openings 16a and 16b of board 16 shown in Fig. 8 are open to the air outside partition board 9 shown in Fig. 5. This configuration allows air passageways 14d and 16d to function as cool-air passages 31.

As shown in Figs. 5 and 6, first blower 18 is attached to the inner side of partition board 9 in order to blow hot air to hot-air passages 30 shown in Fig. 8.

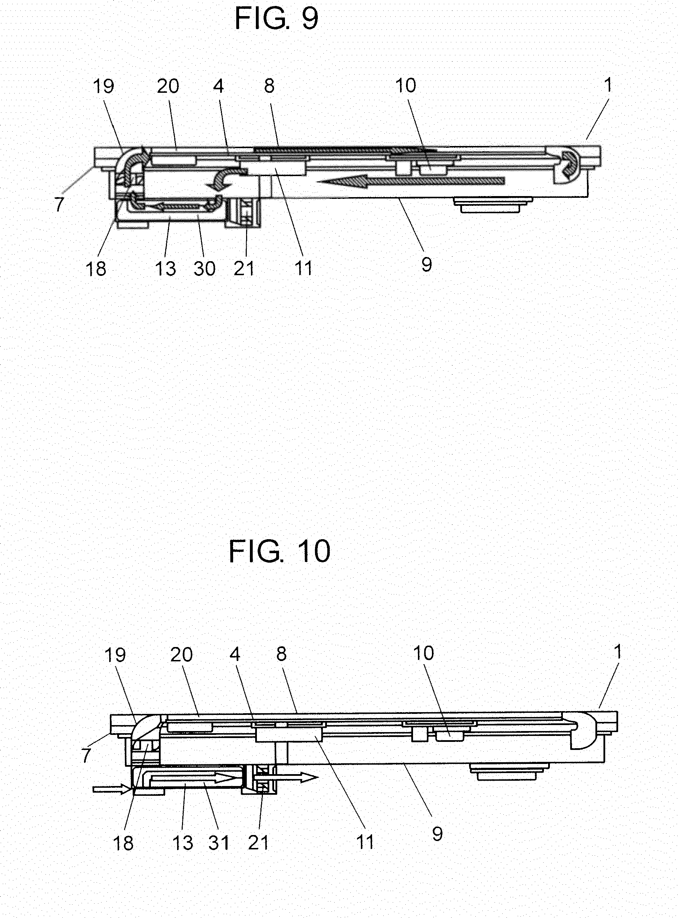

Fig. 9 is a top sectional view of the electronic equipment of the exemplary embodiment of the present invention, showing an airflow generated when the first blower is driven. Fig. 10 is a top sectional view of the electronic equipment, showing an airflow generated when a second blower is driven. As shown in Fig. 9, the air blown by first blower 18 flows through duct 19, blower tube 20 (on the front side of display unit 4), control unit 11, and hot-air passages 30 of heat exchanger 13 in this order, and then returns to first blower 18.

As shown in Fig. 10, second blower 21 is attached to the outer side of partition board 9 in order to blow cooling air to cool-air passages 31. The air blown by second blower 21 flows through cool-air passages 31 of heat exchanger 13, and then returns to second blower 21. Thus, first blower 18 is disposed inside partition board 9, whereas second blower 21 is disposed outside partition board 9.

As shown in Fig. 9, the outer periphery of first blower 18 is disposed inside the rear end of duct 19. The front end of duct 19 is coupled to blower tubes 20 disposed on the rear side of transparent plate 8 and on the front side of display unit 4.

As described before, electronic equipment 1 according to the exemplary embodiment of the present invention includes body case 7, control units 10 and 11, partition board 9, and heat exchanger 13 as shown in Figs 9 and 10. Heat exchanger 13 includes hot-air passages 30, first blower 18, cool-air passages 31, and second blower 21.

This configuration allows hot air generated in body case 7 to be cooled by the heat exchange with the cooling air in heat exchanger 13. Then, the cooled air flows through first blower 18, duct 19, blower tubes 20, control unit 11, and hot-air passages 30 of heat exchanger 13, in this order and returns to first blower 18, thereby cooling display unit 4 and control unit 11.

Boards 14, 15, 16, and 17 shown in Fig. 7, which are extremely thin, do not have to be made of material with high thermal conductivity such as metal. For example, they can be made of a synthetic resin to facilitate weight reduction.

At least one of first blower 18 and second blower 21 shown in Fig. 5 is attached to partition board 9. As a result, during the assembly of electronic equipment 1, the process of attaching first blower 18 and second blower 21 to partition board 9 can be executed in parallel with another process. This improves the efficiency of assembly of the entire electronic equipment 1.

In body case 7, display unit 4 is disposed on the right side of Figs. 9 and 10. This allows first blower 18 and duct 19 to be stored in the space on the left side in body case 7. This also allows cooling air to be blown to the front side of display unit 4.

As shown in Fig. 5, electronic equipment, 1 includes storage space 18a for storing first blower 18 on one side 4b of outer periphery 4a of display unit 4. Storage space 18a is communicated with one end 30a of each of hot-air passages 30. As shown in Fig. 9, the air blown by first blower 18 passes through duct 19, and then through the front side of display unit 4, thereby cooling display unit 4. Next, the air makes a U-turn on the right side, and passes through the rear side of display unit 4, thereby cooling control units 10 and 11. Then, the air passes through second vent 12b of partition board 9 shown in Fig. 5, and is drawn into heat exchanger 13. The air is heat-exchanged with the air in cool-air passages 31 by heat exchanger 13, and is again drawn into duct 19 by first blower 18. This air circulation in body case 7 allows cooled air to pass throughout body case 7 so as to provide uniform cooling.

Display unit 4 needs to be kept at a lower temperature than control units 10 and 11. For this reason, control units 10 and 11 are disposed on the rear side of display unit 4 so that the air blown by first blower 18 can pass through display unit 4 before passing through control units 10 and 11, thereby cooling display unit 4 preferentially. Furthermore, the provision of storage space 18a inside duct 19 can reduce the size of electronic equipment 1 in the thickness direction.

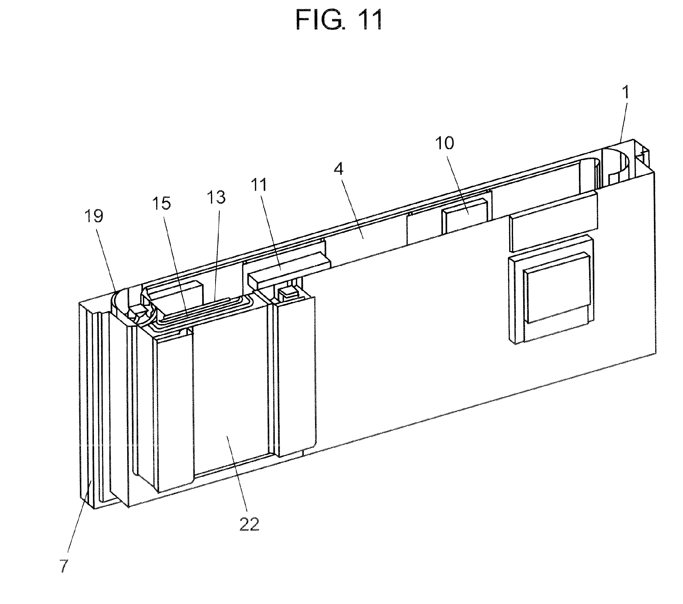

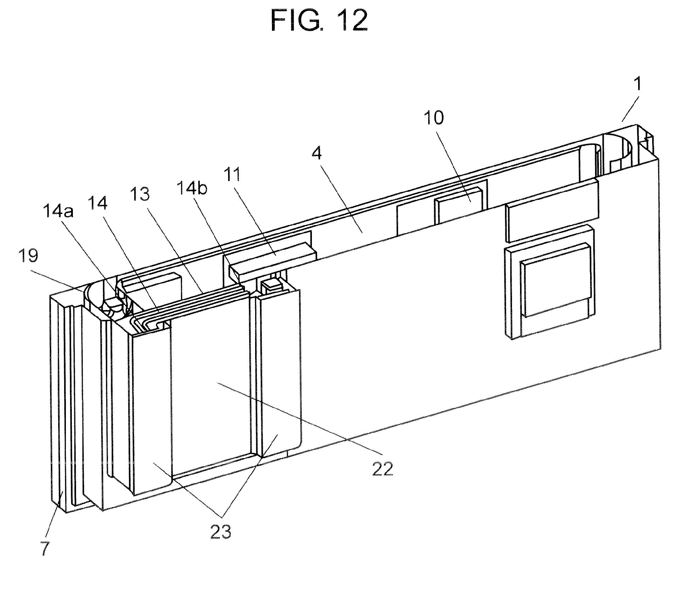

Fig. 11 is a perspective view of the electronic equipment according to an exemplary embodiment of the present invention, showing the hot-air passages. Fig. 12 is a perspective view of the electronic equipment, showing the cool-air passages. Electronic equipment 1 includes cover 22 for protecting heat exchanger 13 from direct sunlight, and sunshade 23 for projecting openings 14a and 14b of heat exchanger 13 from the influence of direct sunlight.

In the exemplary embodiment of the present invention, heat exchanger 13 is disposed on the rear side of display unit 4. Alternatively, heat exchanger 13 can be disposed on a lateral side, the top side, or the bottom side of display unit 4.

### INDUSTRIAL APPLICABILITY

The present invention is expected to be widely used as outdoor electronic equipment.

### REFERENCE MARKS IN THE DRAWINGS

- 1: electronic equipment
- 2: shop
- 3: under the eaves
- 4: display unit
- 4a: outer periphery
- 4b: one side
- 5: front opening
- 6: rear opening
- 7: body case
- 8: transparent plate
- 9: partition board
- 10, 11: control unit
- 12a: first vent
- 12b: second vent
- 13: heat exchanger
- 14, 15, 16, 17: board
- 14a, 14b, 15a, 15b, 16a, 16b, 17a, 17b: opening
- 14c, 15c, 16c, 17c: rib
- 14d, 15d, 16d, 17d: air passageway
- 18: first blower
- 18a: storage space
- 19: duct
- 20: blower tube
- 21: second blower
- 22: cover
- 23: sunshade
- 30: hot-air passage
- 30a: one end
- 31: cool-air passage

## Claims

1. Electronic equipment comprising:
a body case including a display unit on a front side thereof;
a control unit disposed in the body case;
a partition board attached to a rear opening formed on a rear side of the body case so as to separate an inside of the body case from an outside of the body case; and
a heat exchanger attached to the partition board,
wherein the heat exchanger includes:
a hot-air passage for carrying hot air heated in the body case;
a first blower for blowing the hot air into the hot-air passage;
a cool-air passage for carrying cooling air from outside the body case, the cooling air being lower in temperature than the hot air; and
a second blower for blowing the cooling air into the cool-air passage.

2. The electronic equipment of claim 1, wherein
at least one of the first blower and the second blower is attached to the partition board.

3. The electronic equipment of claim 1, wherein
the partition board includes:
a first vent coupled to one end of the hot-air passage; and
a second vent coupled to an other end of the hot-air passage.

4. The electronic equipment of claim 1, wherein
the heat exchanger is attached to an outer side of the partition board.

5. The electronic equipment of claim 1, wherein
the first blower is attached to an inner side of the partition board; and
the second blower is attached to an outer side of the partition board.

6. The electronic equipment of claim 1, wherein
the control unit is disposed on an inner rear side of the body case.

7. The electronic equipment of claim 1, wherein
a storage space for storing the first blower is provided at an outer periphery of the display unit.

8. The electronic equipment of claim 7, wherein
the storage space is provided on one side of the outer periphery of the display unit.

9. The electronic equipment of claim 7, wherein
the storage space is communicated with the one end of the hot-air passage.

10. The electronic equipment of claim 1, wherein
the heat exchanger is composed of a plurality of boards stacked at predetermined intervals;
the boards include air passageways formed by using ribs; and
the air passageways of the boards are assigned as to be the cool-air passage and the hot-air passage in alternate order.
